# EUROPÄISCHE PATENTSCHRIFT

(11) **EP 3 716 742 B1**
(45) Veröffentlichungstag und Bekanntmachung des Hinweises auf die Patenterteilung: **30.04.2025**
(21) Anmeldenummer: 20162354.3
(22) Anmeldetag: 11.03.2020
(51) Int. Cl.: H05K 5/00, H05K 7/14, H05K 7/20

(54) **FREQUENZUMFORMER UND FREQUENZUMFORMERMODUL**
FREQUENCY CONVERTER AND FREQUENCY CONVERTER MODULE
CONVERTISSEUR DE FRÉQUENCE ET MODULE DE CONVERTISSEUR DE FRÉQUENCE

(30) Priorität: 28.03.2019 DE 102019108135
(43) Veröffentlichungstag der Anmeldung: 30.09.2020
(73) Patentinhaber: Wacker Neuson Produktion GmbH & Co. KG, 85084 Reichertshofen (DE)
(72) Erfinder: MEYER, Matthias, 85354 Freising (DE); STEFFEN, Michael, 80796 München (DE); GLANZ, Christian, 85221 Dachau (DE)
(74) Vertreter: Müller Hoffmann & Partner

(56) Entgegenhaltungen:
- DE-A1- 102013 100 607
- DE-A1- 19 900 348
- US-A1- 2016 172 997
- US-A1- 2018 166 995
- US-B1- 6 242 691

## Beschreibung

Die vorliegende Erfindung betrifft Frequenzumformer und Frequenzumformermodule für Innenrüttler und Außenrüttler.

Innenrüttler werden zur Verdichtung von noch flüssigem Beton verwendet. Dazu wird in den Beton eine zu dem Innenrüttler gehörende Rüttelflasche eingetaucht, in der ein Elektromotor und eine von diesem mit hoher Drehzahl angetriebene Unwucht untergebracht sind. Zu Erreichung der erforderlichen Motordrehzahl und damit der gewünschten Verdichtungsfrequenz muss der Motor mit einer Sonderspannung betrieben werden. Die Frequenz dieser Sonderspannung liegt typischer Weise bei 200 Hz und damit höher als eine Netzfrequenz von üblicher Weise 50Hz oder 60Hz. Zudem werden Innenrüttler aus Sicherheitsgründen bei einer Spannung von z.B. 42V betrieben, die unterhalb der typischen Netzspannungen von 400V, 230V oder 120V liegt.

Gleiches gilt für Außenrüttler, wobei diese an eine Schalungswand angebracht werden, in welche Beton gegossen wird. Der bzw. die Außenrüttler versetzen die Schalungswand in Vibration, wodurch der darin befindliche Beton verdichtet wird. Zur Erreichung eines optimalen Verdichtungsergebnisses und zur Anpassung an die jeweils genutzte Schalung ist es vorteilhaft, wenn die Drehzahl des bzw. der Außenrüttler veränderbar ist.

Da Baustellen typischer Weise mit Netzstrom versorgt werden, muss die für den Betrieb von Innen- und Außenrüttlern notwendige Sonderspannung mittels Frequenzumformern erzeugt werden. Diese umfassen üblicher Weise neben der Elektronik zum Wandeln der Netzfrequenz auch Elektronik zum Transformieren der Spannung.

Aufgrund der Tatsache, dass verschiedener Endgeräte verschiedene Betriebsparameter benötigen, existieren eine Vielzahl von Frequenzumformern verschiedener Baugröße. Insbesondere die Abmessungen der Transformatorelektronik können hierbei in Abhängigkeit von der zu transformierenden Spannung und der eingehenden bzw. ausgegebenen Stromstärke stark variieren.

Dadurch bedingt ist es oft nicht möglich, eine Mehrzahl von Frequenzumformern in platzsparender Weise modular anzuordnen. Zudem sind Teile verschiedener Frequenzumformer üblicher Weise nicht austauschbar. Hierdurch ist es notwendig, für jeden Frequenzumformertyp Ersatzteile separat einzukaufen und vorzuhalten. Dies führt zu hohen Kosten beim Einkauf und bei der Lagerhaltung, da eine Vielzahl von Komponenten in kleiner Stückzahl beschafft und auf Vorrat gehalten werden muss.

Aus der US 2016/0172997 A1 ist eine modulare Umformer-Plattform bekannt, bei der mehrere Umformer zum Wandeln einer Gleichspannung in eine Wechselspannung vorgesehen sind. Die Umformer sind nebeneinander auf einem gemeinsamen Träger gehalten und dienen zum Bereitstellen von elektrischem Strom zum Antreiben eines Fahrzeugs. Zu diesem Zweck sind sie fest in das Fahrzeug eingebaut.

In der US 2018/0166995 A1 wird eine ebenfalls fest in ein Fahrzeug eingebaute Umformer-Anordnung gezeigt, mit mehreren Umformern, die mit ihren Gehäusen stapelbar sind.

Diese bekannten Umformer-Anordnungen sind groß und schwer sowie dauerhaft in die Fahrzeuge eingebaut, zu deren Antrieb genutzt werden. Für einen Einsatz auf einer Baustelle eignen sie sich nicht.

Die DE 199 00 348 A1 offenbart eine Steuerung für einen elektromotorischen Innenrüttler.

In der DE 10 2013 100 607 A1 wird ein Wechselrichter mit einem zweiteiligen Gehäuse gezeigt.

Die Aufgabe der Erfindung besteht also darin Frequenzumformer bereitzustellen, die zu einem kompakten, auf einer Baustelle einsetzbaren Frequenzumformermodul kombiniert werden können und die zum größten Teil aus austauschbaren Teilen bestehen.

Diese Aufgabe wird durch den Gegenstand des unabhängigen Anspruchs 1 gelöst.

Insbesondere weist ein Frequenzumformer zum Umformen einer Netzfrequenz in eine höhere Frequenz eine Umformeraufnahme auf, in der eine Platine luftdicht vergossen ist, die zum Transformieren eines an die Platine angelegten elektrischen Stroms hinsichtlich seiner Frequenz, seiner Spannung und/oder seiner Phasenanzahl und zum Ausgeben des transformierten elektrischen Stroms geeignet ist. Der Frequenzumformer weist des Weiteren ein Gehäuse zum Aufnehmen der Umformeraufnahme auf, wobei das Gehäuse derart ausgebildet ist, dass es mit einem Gehäuse eines gleichartig aufgebauten weiteren Frequenzumformers formschlüssig verbunden werden kann.

Eine derartige Klasse von Frequenzumformern zeichnet sich also dadurch aus, dass alle Frequenzumformer ein gleichartig aufgebautes Gehäuse aufweisen, dass mit den Gehäusen der übrigen Frequenzumformer in modulartiger Weise, gleichsam nach dem "Legoprinzip" formschlüssig verbunden werden kann. Hierdurch wird ein kompakter Zusammenschluss der Frequenzumformer ermöglicht.

Andererseits liegt in jedem Gehäuse der Frequenzumformer eine Umformeraufnahme vor, in die eine Platine mit der Umformer- bzw. Transformationselektronik witterungsbeständig und wasserdicht eingeschlossen ist. Verschiedene Frequenzumformer können also trotz gleicher äußerer Form verschiedene Ausgangsströme erzeugen. Da jedoch nur die Elektronik der Platinen unterschiedlich ausgestaltet ist, während alle anderen Teile, wie z.B. elektrische Leitungen, Steckdosen, Anzeigen, Kühlungen und dergleichen identisch aufgebaut sind, ist es möglich, einen Satz von Ersatzteilen für sämtliche Frequenzumformer der gleichen Gehäuseform vorzuhalten. Dadurch verbilligt sich der Einkauf dieser Teile, da weniger Teile in größerer Stückzahl beschafft werden können.

Die Platine kann eine Transformatorschaltung zum Transformieren der Spannung des angelegten Stroms aufweisen, vorzugsweise von einer Netzspannung von insbesondere 400V, 230V oder 120V auf eine niedrigere Spannung. Zudem kann die Platine eine Frequenzwandelschaltung zum Transformieren der Frequenz des angelegten Stroms aufweist, vorzugsweise von einer Netzfrequenz von insbesondere 50Hz oder 60Hz auf eine höhere Frequenz. Frequenzumformer mit verschiedenen Ausgabecharakteristiken weisen also die gleiche äußere Abmessung auf. Insbesondere sind für die Spannungswandlung vorgesehene Transformatoren auf der Platine integriert und verändern auch für verschiedene Stromstärken und Ausgangsspannungen nicht mehr die Gesamtabmessungen der Frequenzumformer. Hierdurch wird eine modulare Kombinierbarkeit von Frequenzumformer verbessert.

Die Frequenz des transformierten elektrischen Stroms kann hierbei eingestellt werden. Dies erlaubt es, Innen- und/oder Außenrüttler mit verschiedenen Vibrationsfrequenzen zu betreiben.

Das Gehäuse weist eine Kühlvorrichtung zum Kühlen der Platine auf, mit zumindest einem Ventilator, der geeignet ist, Luft von einem Lufteinlass des Gehäuses über einen entlang der Umformeraufnahme führenden Luftkanal zu einem Luftauslass des Gehäuses zu führen. Dies erlaubt eine effektive Kühlung der Umformerelektronik, da ein kühlender Luftstrom längs der Umformeraufnahme geführt wird, ohne verschiedene Luftströme zu durchmischen. Insbesondere ist es möglich, durch zwei mittels Ventilatoren mit Luft versorgte Luftkanäle, die sich nicht kreuzen, die Umformeraufnahme zu kühlen.

Der Luftkanal ist hierbei zweifach geneigt, derart dass in den Luftkanal gelangte Flüssigkeit in einer Betriebsstellung des Frequenzumformers zum Lufteinlass und zum Luftauslass hin abläuft. Dadurch kann z.B. durch Regen oder bei der Reinigung eingedrungenes Spritzwasser zügig aus dem Gehäuse des Frequenzumformers abgeführt werden. Der Frequenzumformer entspricht damit der Schutzart IP44.

Der Luftkanal kann auch durch Kühlrippen der Umformeraufnahme laufen.

Dadurch wird eine effektive Wärmeabführung von der Platine über die Kühlrippen der Umformeraufnahme in den kühlenden Luftstrom gewährleistet.

Das Gehäuse kann eine Signalisation für verschiedene Betriebszustände aufweisen, vorzugweise für einen der folgenden Betriebszustände: Betrieb des Frequenzumformers, Wartung notwendig, Überstrom, Überspannung, Übertemperatur. Hierdurch ist es bei Arbeiten mit dem Frequenzumformer möglich, relevante Betriebsparameter abzulesen und bei Störungen geeignete Gegenmaßnahmen zu ergreifen. So kann z.B. bei einer (zu erwartenden) Überhitzung ein angeschlossenes Gerät von dem überhitzten (bzw. überhitzenden) Frequenzumformer getrennt und an einen anderen Frequenzumformer angeschlossen werden, der sich z.B. im gleichen Modul befindet.

Ein Frequenzumformermodul weist zumindest einen Frequenzumformer auf, wie er oben beschrieben wurde. Zudem weist das Frequenzumformermodul einen Boden und einen Deckel auf, zwischen denen der zumindest eine Frequenzumformer angeordnet ist. Das Gehäuse des zumindest einen Frequenzumformers ist hierbei derart ausgebildet, dass ein weiterer gleichartig aufgebauter Frequenzumformer an der Oberseite oder der Unterseite des zumindest einen Frequenzumformers formschlüssig mit diesem verbunden werden kann, dass der Boden an der Unterseite des zumindest einen Frequenzumformers formschlüssig mit diesem verbunden werden kann, und dass der Deckel an der Oberseite des zumindest einen Frequenzumformers formschlüssig mit diesem verbunden werden kann.

Mehrere Frequenzumformer können also aufgrund ihres gleichen Aufbaus übereinander gestapelt angeordnet werden. Zudem ist durch das Vorsehen eines Bodens und eines Deckels ein witterungsbeständiger Abschluss des Moduls gewährleistet. Der Deckel kann zudem mit einem Griff zum Tragen des Moduls versehen sein. Eine Stromzuführung zu den einzelnen Frequenzumformern erfolgt vorzugsweise über den Deckel oder den Boden, eine Aufteilung des eingehenden Stroms auf die einzelnen Frequenzumformer kann dann entsprechend der anliegenden Belastung durch angeschlossene Endgeräte erfolgen. Dies ermöglicht eine kompakte, sichere und transportable Verwendung sowohl eines einzelnen Frequenzumformers als auch einer Mehrzahl von Frequenzumformern.

Es können zumindest zwei Frequenzumformer zwischen dem Boden und der Decke angeordnet sein, die unterschiedliche Stromstärken ausgeben, vorzugsweise aus der Gruppe von 20A, 35A und 54A. Wie bereits oben erläutert können also Frequenzumformer mit verschiedenen Ausgangsparametern modular und kompakt miteinander verbunden werden.

Eine Außenwand des Gehäuses des zumindest einen Frequenzumformers kann Steckdosen zum Ausgeben des transformierten elektrischen Stroms aufweisen. Der Boden, der Deckel und an die Außenwand anschließende Teile des Gehäuses können gegenüber der Außenwand derart vorspringen, dass sie sich weiter von der Außenwand weg erstrecken als die Steckdosen. Hierdurch wird durch seitlich vorspringende Wangen des Gehäuses des Frequenzumformers zusammen mit Boden und Decke ein Schlagschutz für die Steckdosen des Frequenzumformers erzeugt.

Der Deckel kann ein Potentiometer aufweisen, dass derart mit zwischen dem Boden und dem Deckel angeordneten Frequenzumformern verschaltete werden kann, dass über das Potentiometer ausgegebene Frequenzen eines, eines Teils oder aller Frequenzumformer eingestellt werden können. Damit wird ermöglicht, während eines laufenden Baustellenbetriebs die für verschiedene, an dem Frequenzumformermodul angeschlossene Innenrüttler zur Verfügung gestellten Frequenzen in gleicher oder in unterschiedlicher Weise zu variieren.

Die Frequenzumformer können ineinander gesteckt und durch Befestigungsmittel wie Verbindungsbolzen oder Gewindestangen aneinander und an dem Boden und der Decke befestigt werden. Das Frequenzumformermodul kann also in einfacher Weise zusammengefügt und wieder auseinandergenommen werden. Insbesondere können auch nachträglich noch weitere Frequenzumformer in das Frequenzumformermodul eingebaut werden. Die für das Befestigen verwendeten Befestigungsmittel können hierbei für alle Befestigungen identisch sein, z.B. kann eine Art von Bolzen für sämtliche Verbindungen verwendet werden. Hierdurch reduziert sich die Anzahl von vorzuhaltenden Ersatzteilen weiter.

Das Frequenzumformermodul kann ein Modul mit einem Gehäuse aufweisen, das identisch zu dem Gehäuse des zumindest einen Frequenzumformers ausgebildet ist. Dieses Modul kann geeignet sein, einen eingehenden Netzstrom über Steckdosen weiterzuleiten. Neben Frequenzumformern kann in dem Frequenzumformermodul also auch ein als Steckdosenträger fungierendes Modul vorgesehen sein, das zur Ausgabe des Netzstroms dient. Zudem können auch Module beliebiger anderer Funktion vorgesehen sein, solange diese sich mit einem baugleich ausgeführten Gehäuse realisieren lassen.

Der Boden kann als Schlitten ausgebildet sein. Dies erlaubt es, das Frequenzumformermodul in einfacher Weise über eine Baustelle zu ziehen, insbesondere über in der Baustelle liegende Bewehrungen. Hierdurch wird der Einsatz des Frequenzuumformermoduls vereinfacht.

Im Folgenden wird die Erfindung beispielhaft anhand der Figuren beschrieben. Die Erfindung ist hierbei aber nicht durch die beschriebenen Beispiele, sondern allein durch den Gegenstand der Ansprüche bestimmt. Es zeigen:
- **Fig. 1A und 1B**: schematische Explosionsdarstellungen von in Frequenzumformermodulen verbauten Frequenzumformern;
- **Fig. 2A und 2B**: schematische Ansichten der Frequenzumformermodule;
- **Fig. 3A und 3B**: schematische Seitenansichten der Frequenzumformermodule;
- **Fig. 4A und 4B**: schematische Ansichten der in den Frequenzumformermodulen verbauten Frequenzumformer;
- **Fig. 5A und 5B**: schematische Querschnittsansichten der Frequenzumformermodule; und
- **Fig. 6**: eine schematische Ansicht einer Umformeraufnahme.

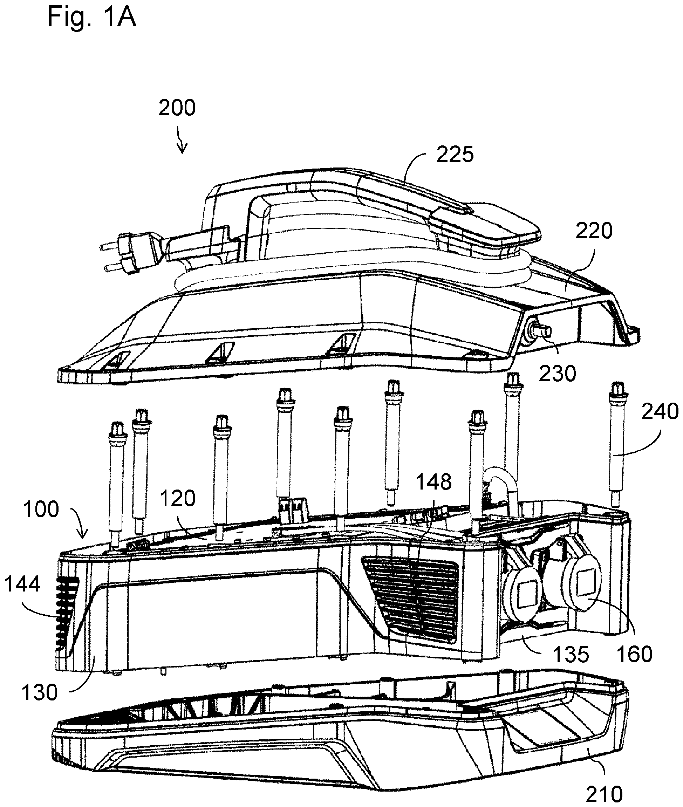

Im Folgenden werden aus mehreren Frequenzumformern 100 mit gleicher äußerer Bauform zusammengesetzte Frequenzumformermodule 200 beschrieben. Die Fig. 1A bis 5B zeigen hierbei verschiedene Ansichten eines Frequenzumformermoduls 200 mit einem Frequenzumformer 100 und eines Frequenzumformermoduls 200 mit zwei Frequenzumformern 100. Frequenzumformermodule 200 können aber auch mehr als zwei Frequenzumformer 100 aufweisen, die entsprechend des Beispiels mit zwei Frequenzumformern 100 übereinander gestapelt sind.

Kernstück der Frequenzumformermodule 200 ist zumindest ein Frequenzumformer 100, der zum Umformen von Netzfrequenzen in höhere Frequenzen geeignet ist, wie sie z.B. zum Betrieb von Innenrüttlern nötig sind.

Der Frequenzumformer 100 weist eine Platine 120 auf, die sämtliche für die Transformation eines eingehenden Netzstroms nötigen Bauteile aufweist. Insbesondere weist die Platine eine Transformatorschaltung zum Transformieren einer Netzspannung und eine Frequenzwandelschaltung zum Umwandeln einer Netzfrequenz in eine höhere Frequenz auf. Optional kann die Platine auch Elektronik zum Wandeln eines 1-Phasenstroms in einen 3-Phasenstrom aufweisen. Der Netzstrom kann hierbei eine Spannung von 400V, 230V oder 120V und eine Frequenz von 50Hz oder 60Hz aufweisen. Bei Spannung von 400V ist der Netzstrom 3-phasig. Vorzugsweise wird der Frequenzumformer mit 1-Phasenstrom betrieben. Dies erleichtert den Betrieb, da es dann nicht notwendig ist, einen allstromsensitiven FI-Schutzschalter vorzuhalten.

Die Platine ist in der Lage die Frequenz des Netzstroms auf mehr als 200Hz hochzusetzen, während die Spannung auf 42V oder weniger transformiert wird. Die Ausführung der Elektronik um diese Transformationen durchführen zu können, ist hierbei bekannt und braucht nicht weiter ausgeführt zu werden.

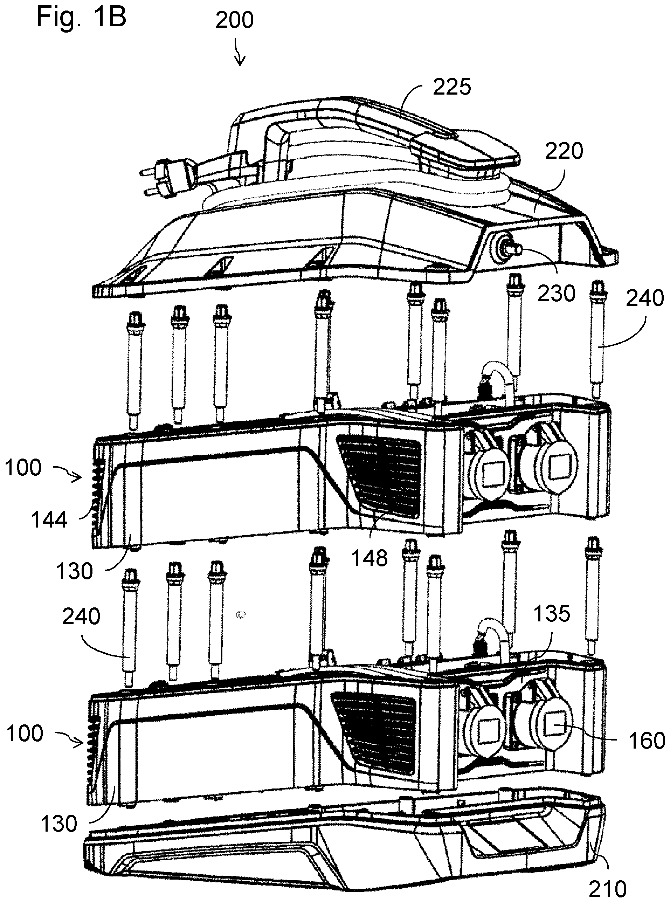

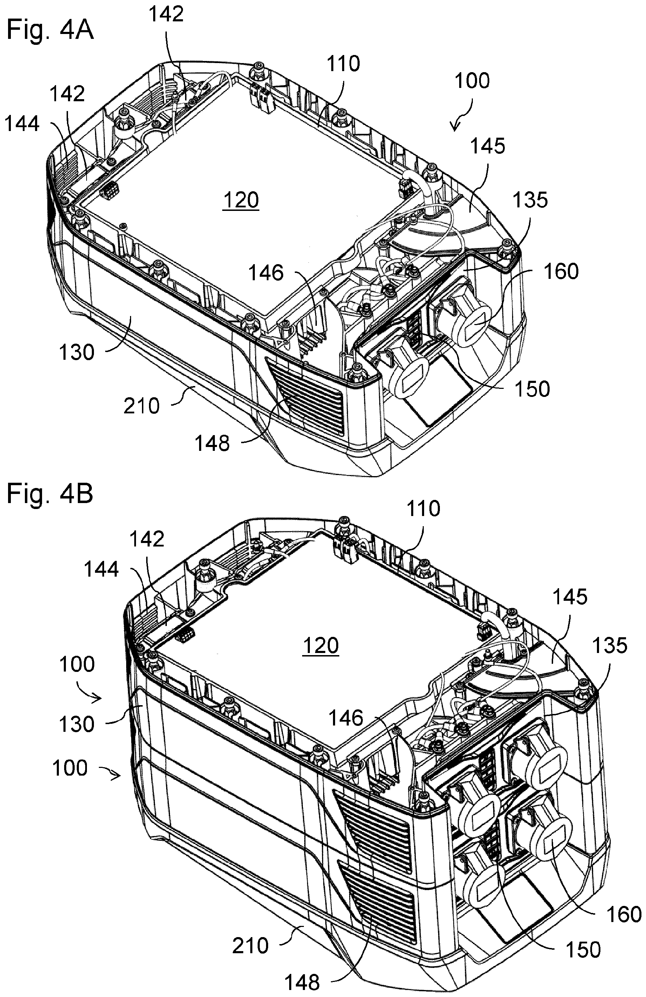

Wie z.B. in den Fig. 1B, 4A und 4B dargestellt können die Platinen 120 verschiedener Frequenzumformer 100 gleich dimensioniert sein. Es werden also auch für unterschiedliche Stromwandlungen bzw. Frequenzumformungen Platinen 120 mit den gleichen Maßen verwendet. Die für die jeweilige Stromwandlung notwendigen elektronischen Komponenten sind deshalb derart ausgewählt, dass eine (im Wesentlichen) einheitliche Platinengröße sichergestellt ist. Insbesondere ändern auch auf der Platine vorhandene Transformatoren für die Spannungswandlung die Ma-ße der Platine nicht, selbst wenn sie für das Wandeln von Eingangsströmen mit verschiedenen Stromstärken oder für das Ausgeben von verschiedenen Stromstärken ausgelegt sind, z.B. auf Ausgangsstromstärken von 20A, 35A oder 54A.

Die Platine 120 ist in einer Umformeraufnahme 110 aufgenommen, die typischerweise aus Aluminium oder einem andere Material mit hoher Wärmeleitfähigkeit und ausreichender Stabilität ausgebildet ist. Die Platine 120 ist in der Umformeraufnahme witterungsbeständig, z.B. luftdicht und/oder wasserdicht, vergossen. Der Eingangsstrom wird der Platine 120 über Anschlüsse zugeführt. Ebenso wird der transformierte elektrische Strom über Anschlüsse abgeführt. Auch die Umformeraufnahme 110 kann hierbei für verschiedene Frequenzumformer 100 die gleiche Gestalt aufweisen. Die elektrischen Eigenschaften eines Frequenzumformers 100 können also durch Auswechseln der Umformeraufnahme 110 bzw. der darin befindlichen Platine 120 in einfacher Weise verändert werden.

Die Umformeraufnahme 110 ist in einem Gehäuse 130 des Frequenzumformers 100 angeordnet, das die äußere Form des Frequenzumformers 100 definiert. Das Gehäuse 130 ist hierbei für alle Frequenzumformer 100 gleich aufgebaut und erlaubt es die Frequenzumformer 100 modular und in formschlüssiger Weise miteinander zu verbinden. Die Maße der Platine 120 und der Umformeraufnahme 110 müssen sich zumindest soweit gleichen, dass sie in die baugleich ausgeführten Gehäuse der verschiedenen Frequenzumformer 100 passen. "Baugleich ausgeführt" soll hier auch Gehäuse 130 einschließen, deren Außenkontur es erlaubt, die Gehäuse 130 formschlüssig aufeinander zu stapeln. So werden als baugleiche Gehäuse 130 auch solche angesehen, die sich nur in ihrer Höhe oder der Anordnung von innen- oder außenliegenden Komponenten unterscheiden, wie sie weiter unten beschrieben werden.

Wie z.B. in der Fig. 1B gezeigt, lassen sich die Gehäuse 130 verschiedener Frequenzumformer 100 aufeinander stecken und durch Befestigungsbolzen 240 oder äquivalente Befestigungsmittel wie Gewindestangen oder dergleichen miteinander verbinden. Der Bodenbereich des Gehäuses 130 kann dabei derart ausgebildet sein, dass er z.B. mittels Nut und Feder in ein darunterliegendes Gehäuse 130 eingreift und dieses gegen seitliche Verschiebungen stabilisiert. Auf diese Weise ist es möglich, mehrere Frequenzumformer in modularer Weise, gleichsam wie Lego-Steine aufeinander zu stecken, um ein Frequenzumformermodul zu schaffen. Alternativ zur gezeigten Schichtbarkeit nach oben ist auch jede andere modulartige Verknüpfung möglich, die auf der gleichen äußeren Form der Gehäuse 130 basiert, z.B. ein seitliches Nebeneinanderstellen oder eine kranzförmige Anordnung mit keilförmig ausgestalteten Frequenzumformern.

Neben der Umformeraufnahme 110 weist das Gehäuse 130 sämtliche weiteren elektrischen Bauteile auf, die es erlauben, Netzstrom an die Platine anzulegen und transformierten elektrischen Strom zu entnehmen. Insbesondere weist das Gehäuse 130 Zuleitungen zur Platine 120 auf, über die der Netzstrom eingespeist wird. Die Zuleitungen können hierbei direkt über eine Gehäusewand mit Netzstrom versorgt werden. Alternativ kann, wie in den Figuren gezeigt, Netzstrom zentral über das Frequenzumformermodul 200 an die einzelnen Frequenzumformer 100 verteilt werden.

Von der Platine 120 führen Leitungen für den transformierten Strom zu Steckdosen 160, die an einer Außenwand 135 des Gehäuses angeordnet sind. Hierbei ist jede Anzahl von Steckdosen denkbar, nicht nur die gezeigte Anzahl von zwei Steckdosen. Zudem ist es möglich, mittels einer Platine 120 verschiedene Ausgangsströme an verschiedene Steckdosen 160 zu legen.

Die in den einzelnen Frequenzumformern 100 verwendeten elektrischen Bauteile wie etwa Leitungen, Steckdosen 160 und dergleichen können in jedem Frequenzumformer 100 identisch sein. Hierdurch lassen sich die elektrischen Bauteile aller Frequenzumformer 100 durch einen einzigen Satz von Ersatzteilen bedienen.

Neben den für die Leitung des Stroms nötigen Bauteilen kann das Gehäuse 130 weitere Komponenten enthalten. So können die Frequenzumformer 100 eine Signalisation 150 für Betriebszustände und eine Kühlvorrichtung zum Kühlen der Platine 120 aufweisen.

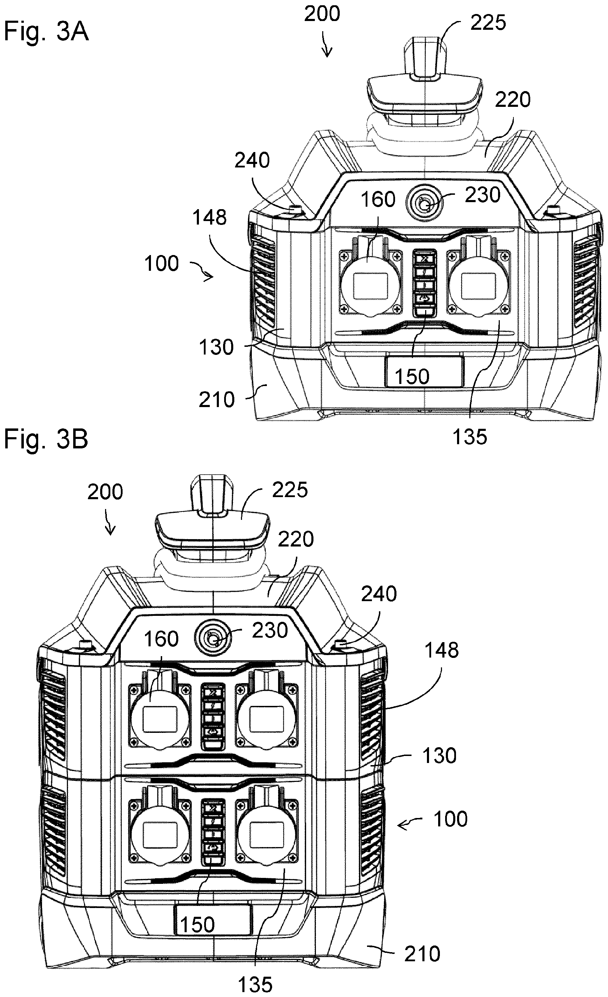

Die Signalisation 150 kann hierbei z.B. aus verschiedenen Leuchtanzeigen bestehen, z.B. aus LED-Leuchten, Glühlampen oder einem LCD-Feld. Die Signalisation 150 kann verschiedene Betriebszustände anzeigen, wie z.B. einen Betrieb des Frequenzumformers 100, die Notwendigkeit einer Wartung, und/oder das Auftreten von Überstrom, einer Überspannung und/oder einer Übertemperatur, bzw. die Gefahr eines solchen Auftretens. Wie z.B. in den Fig. 3A und 3B gezeigt, kann sich die Signalisation 150 im Bereich des Anschlusses für Arbeitsgeräte, wie z.B. Innenrüttler befinden, d.h. an der Außenwand 135. Dadurch wird ein Bediener des Frequenzumformermoduls 200 beim Verbinden des Arbeitsgeräts auf den anliegenden Betriebszustand hingewiesen und kann bei Störungen entsprechend reagieren, z.B. durch Abschalten oder Nichtbenutzen des Frequenzumformers 100. Hierdurch erhöht sich die Sicherheit und die Verlässlichkeit der Arbeit mit dem Frequenzumformer 100.

Die Signalisation 150 kann aber auch an jeder anderen von außen einsehbaren Stelle des Frequenzumformers 100 angebracht sein. Zudem ist es auch möglich, eine zentrale Signalisation für alle in einem Frequenzumformermodul 200 angeordneten Frequenzumformer 100 vorzusehen.

Die Kühlvorrichtung dient dazu, die bei der Transformation der Netzspannung entstehende Wärme abzuführen und dadurch ein Überhitzen der Platine 120 zu verhindern. Die Kühlvorrichtung kann jede beliebige Form aufweisen, die einen sicheren Betrieb des Frequenzumformers 100 garantiert. Wie in den Figuren gezeigt, besteht die Kühlvorrichtung des anspruchsgemässen Frequenzumformermoduls aus einem Kühlluftsystem, das Luft mittels eines Ventilators 142 in einen Lufteinlass 144 im Gehäuse 130 saugt, um die Luft in einem Luftkanal 146 an der Umformeraufnahme 110 vorbei zu leiten und über einen Luftauslass 148 im Gehäuse 130 auszustoßen.

Wie in den Fig. 4A und 4B gezeigt, können in jedem Frequenzumformer 100 zwei über jeweilige Ventilatoren 142 versorgte Luftkanäle 146 vorhanden sein, die unter der Umformeraufnahme 110 verlaufen. Es kann aber auch jede andere Anordnung von Kühlluftkanälen verwendet werden, solange eine ausreichende Kühlung der Platine 120 sichergestellt ist.

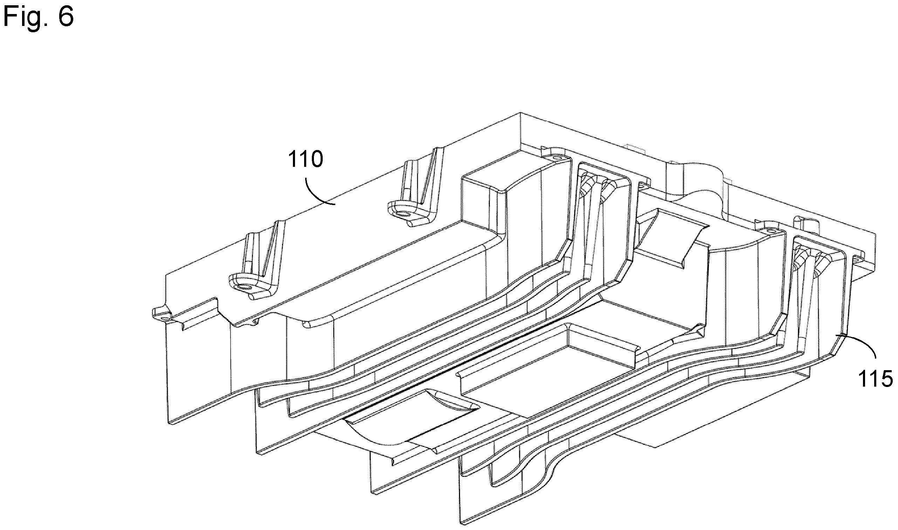

Wie in den Fig. 4A und 4B zu sehen ist, verlaufen die Luftkanäle 146 entlang der Unterseite der Umformeraufnahme 110. Diese kann, wie in Fig. 6 gezeigt, Kühlrippen 115 aufweisen, zwischen denen die Luft hindurchströmt. Dies gewährleistet einen hohen Wärmeaustausch und damit einer verlässliche Kühlung. Die Kühlleistung wird zudem auch dadurch verbessert, dass die beiden vorhandenen Luftkanäle 146 sich nicht kreuzen, wodurch eine dem Abtransport der Wärme hinderliche Vermischung der Luftströme verhindert würde.

Die Umformeraufnahme 110 liegt, wie in den Fig. 4A und 4B gezeigt, auf dem Boden des Gehäuses 130 auf. Zum Abdichten des durch die Kühlrippen 115 und den Boden des Gehäuses 130 definierten Luftkanals 146 können Gummi- oder Schaumstoffmatten auf dem Gehäuseboden angebracht sein, auf denen die Kühlrippen 115 aufsitzen. Des Weiteren können Abdeckungen 145 vorgesehen sein, die die Zwischenräume zwischen den Kühlrippen 115 und den Lufteinlässen 144 und den Luftauslässen 148 abdecken. Hierdurch wird verhindert, dass Luft den für den Kühlprozess erwünschten vordefinierten Pfad verlässt, wodurch der Kühlprozess effizienter und verlässlicher wird.

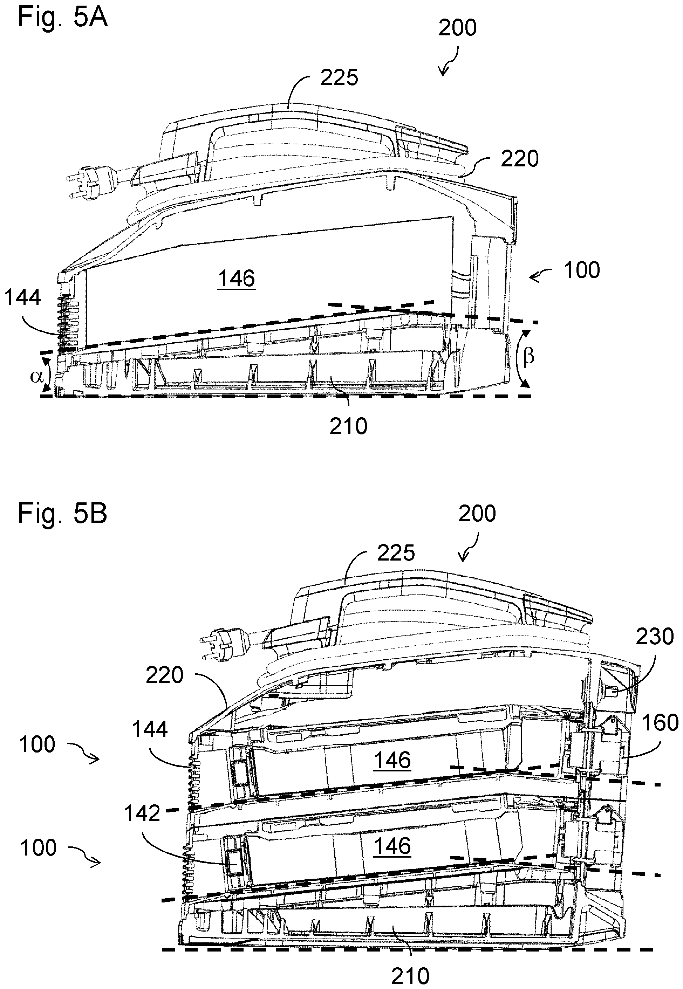

Wie in den Fig. 5A und 5B gezeigt ist der Gehäuseboden im Bereich der Luftkanäle 146 derart geneigt, bzw. geknickt, dass Flüssigkeiten wie Wasser aus dem Luftkanal 146 auf den Lufteinlass 144 und den Luftauslass 148 zu ablaufen. Wie durch die gestrichelten Linien in den Fig. 5A und 5B gezeigt, kann dies dadurch erreicht werden, dass bei Betrieb der Frequenzumformer 100 der zum Lufteinlas 144 zeigende Bereich des Gehäusebodens einen Winkel α mit der Standfläche des Frequenzumformermoduls 200 einschließt und der zum Luftauslass 148 zeigende Bereich einen Winkel β, der sich vom Winkel α unterscheiden kann, aber nicht muss.

Bei Reinigungsarbeiten oder aufgrund von Regenfällen in die Luftkanäle 146 gelangtes Wasser läuft also von selbst aus dem Gehäuse 130 ab. Bei einer Abdichtung der Luftkanäle 146 gegenüber dem Rest des Gehäuses 130, wie sie z.B. durch das Vorsehen von Schaumstoffmatten auf dem Gehäuseboden erreicht wird, wird gewährleistet, dass jeder Frequenzumformer 100 für sich genommen der Schutzart IP44 entspricht. Jeder Frequenzumformer 100 genügt für sich genommen deshalb hohen Sicherheitsstandards.

Wie auch die elektrischen Bauteile des Frequenzumformers 100 können auch sämtliche übrigen Bauteile des Frequenzumformers 100 wie sie oben beschrieben wurden für jeden Frequenzumformer 100 gleich ausgestaltet sein. Das heißt insbesondere, dass Ventilatoren 142 und Signalisation 150 in jedem Frequenzumformer 100 gleich ausgebildet sein können. Diese Teile sind also zwischen den einzelnen Frequenzumformern 100 austauschbar, wodurch sich die Menge der für die verschiedenen Frequenzumformer 100 notwendigen Bau- bzw. Ersatzteile reduziert.

Die einzelnen Frequenzumformer 100 sind in dem Frequenzumformermodul 200 zwischen einem Boden 210 und einem Deckel 220 des Frequenzumformermoduls 200 angeordnet. Der Kontaktbereich des Bodens 210 ist hierbei von der gleichen Form, wie die Oberseite des Gehäuses 130 der Frequenzumformer, während die Unterseite des Deckels 220 der Unterseite des Gehäuses 130 entspricht. Der Boden 210 und der Deckel 220 können also in gleicher Weise wie die Frequenzumwandler 100 untereinander mit den jeweils zuäußerst liegenden Frequenzumwandlern 100 formschlüssig verbunden werden.

Um ineinander gesteckte Frequenzumwandler 100 miteinander und mit dem Boden 210 und der Decke 220 zu verbinden, können gleichartige Befestigungsmittel, wie etwa die in den Fig. 1A und 1B gezeigten Verbindungsbolzen 240 verwendet werden. Dies hat den Vorteil, dass mit eine einzigen Art von Befestigungsmittel sämtliche Komponenten des Frequenzumformermoduls 200 miteinander verbunden werden können. Auch hierdurch werden die für den Zusammenbau und die Instandhaltung des Frequenzumformermoduls 200 notwendigen Bauteile reduziert.

Ineinander gesteckte Frequenzumformer 100, Boden 210 und Decke 220 werden mittels der in den Fig. 1A und 1B gezeigten Verbindungsbolzen 240 verschraubt. Für die Demontage werden die Verbindungsbolzen 240 durch Verdrehsicherungen festgehalten, um den oberen Anteil von Schraub und Verbindungsbolzen lösen zu können. Dies erlaubt eine einfache Montage und Demontage des Frequenzumformermoduls. Es versteht sich aber von selbst, dass auch jede andere Art von Befestigungsmitteln möglich ist, wie z.B. unterschiedlich lange Verbindungsbolzen, Gewindestangen oder versetzte Anschraubstellen in zweifacher Ausführung, falls diese als vorteilhaft angesehen werden.

Durch diesen modulartigen Aufbau können also in einfacher Weise Frequenzumformer 100 je nach Bedarf in das Frequenzumformermodul 200 eingesetzt oder daraus entnommen werden. Insbesondere kann bei Ausfall eines Frequenzumformers 100 dieser separat entnommen und zur Reparatur gegeben werden, ohne das gesamte Frequenzumformermodul 200 von der Baustelle entfernen zu müssen. Dadurch kann eine Unterbrechung von Arbeiten auf der Baustelle verhindert werden.

Der Deckel 220 kann wie in den Figuren gezeigt einen Griff aufweisen, der erlaubt, das Frequenzumformermodul 200 zu tragen. Zudem kann der Deckel 220 einen Netzstecker aufweisen, über den die in dem Frequenzumformermodul 200 angeordneten Frequenzumformer 100 mit Netzstrom versorgt werden können. Der Netzstecker kann aber auch im Boden 210 angeordnet sein. Alternativ können auch die einzelnen Frequenzumformer 100 mit eigenen Netzsteckern versehen sein. Der über den Netzstecker eingespeiste Strom kann entsprechend der an den Frequenzumformern 100 anliegenden Lasten auf die Frequenzumformer 100 verteilt werden. Dies kann direkt geschehen, z.B. durch eine direkte Verbindung mit den Platinen 120 der Frequenzumformer 100. Falls dies vorteilhaft ist, kann der Strom vom Netzstecker aber auch noch weitere elektrische Bauteile durchlaufen, um z.B. eine der Transformation in den Platinen 120 vorgeschaltete Transformation durchzuführen.

Wie in den Figuren gezeigt, kann ein Potentiometer 230 im Deckel 220 angeordnet sein. Das Potentiometer 230 kann dazu verwendet werden, die von den Frequenzumformern 100 des Frequenzumformermoduls 200 ausgegebene Frequenz einzustellen. Die Frequenzanpassung mittels eines Potentiometers ist hierbei bekannt und braucht deshalb hier nicht erläutert zu werden. Das Potentiometer 230 kann mit den Platinen 120 der Frequenzumformer 100 verbunden sein, die einer Steuerung zugänglich sein sollen. Auf diese Weise kann ein Teil der Frequenzumformer 100 mit einem hinsichtlich der Frequenz verstimmbaren Stromausgang versehen sein, der z.B. dazu verwendet werden kann, die Vibrationsfrequenz eines Innenrüttlers bzw. den Ausgangsstrom an die für einen Außenrüttler notwendigen Bedingungen anzupassen. Das Potentiometer 230 kann auch an jeder anderen Stelle des Frequenzumformermoduls 200 angeordnet sein. Zudem können auch die einzelnen Frequenzumformer 100 Potentiometer für die Frequenzeinstellung aufweisen.

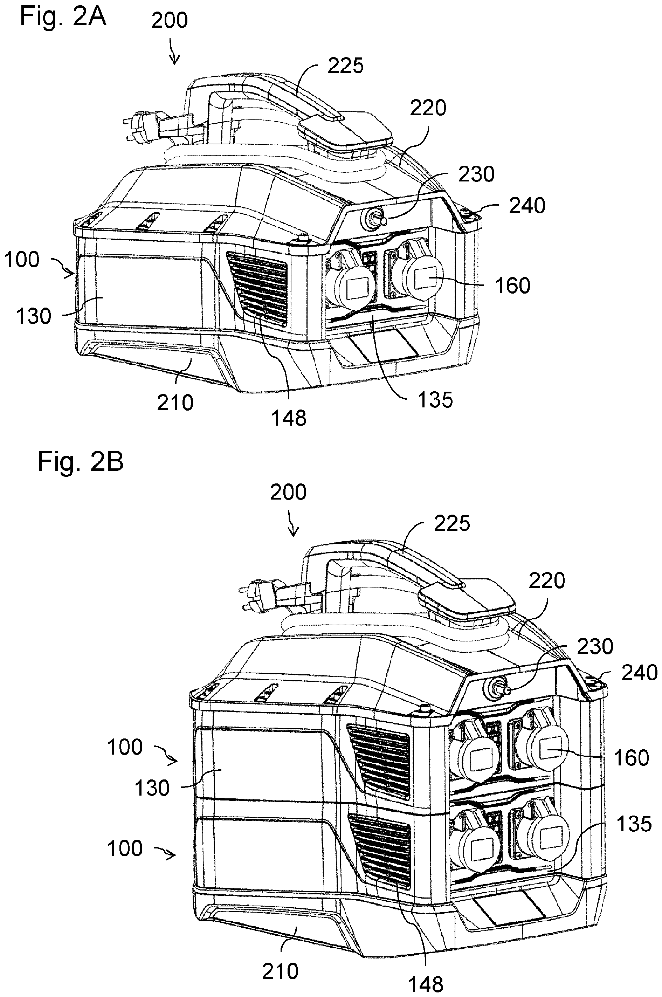

Wie aus den Figuren ersichtlich wird, bilden die Außenwände der Gehäuse 130 der Frequenzumformer 100, der Boden 210 und der Deckel 220 die Außenkontur des Frequenzumformermoduls 200. Wie insbesondere aus den Fig. 2A und 2B ersichtlich, kann diese Außenkontur zum Schutz der außen an den Frequenzumformern 100 angeordneten Bauteile gegen Außeneinwirkungen, wie Schläge oder Stöße verwendet werden.

Hierzu ist eine Außenwand 135 an der schützenswerte Bauteile angeordnet sind, hier die Steckdosen 160 und die Signalisation 150, gegenüber an die Außenwand angrenzenden Teilen des Gehäuses 130 nach hinten versetzt. Gleichzeitig stehen der Boden 210 und der Deckel 220 im Bereich der Außenwand 135 soweit vor, dass sie formschlüssig mit den am weitesten vorstehenden Bereichen des Gehäuses 130 sind. Das Gehäuse 130 bildet also vorstehende Wangen um die Außenwand, die zusammen mit dem Boden 210 und dem Deckel 220 einen Schlagschutz für die an der Außenwand 135 angeordneten Komponenten bieten. Anders ausgedrückt ist die Außenwand 135 gegenüber den sie umgebenden Teilen von Gehäuse 130, Boden 210 und Deckel 220 genügend weit zurückgesetzt, dass die daran angeordneten Komponenten nicht überstehen.

Wie in den Fig. 2A und 2B gezeigt, kann diese Prinzip auch auf Teile des Bodens 210 und des Deckels 220 ausgeweitet werden, so dass durch die Gehäuse 130 der verschiedenen Frequenzumformer 100, den Boden 210 und den Deckel 220 ein Rahmen gebildet wird, gegenüber den innenliegende Teile der Gehäuse 130, des Bodens 210 und des Deckels 220 zurückgesetzt sind. In einer derartigen Vertiefung des Deckels 220 kann dann z.B. das Potentiometer 230 angeordnet sein. Hierdurch kann an dem Frequenzumformermodul 200 ein gegenüber Schlägen und Stößen geschützter Bereich erzeugt werden, in dem relativ empfindliche Bauteile angebracht werden können. Hierdurch wird die Lebensdauer dieser Bauteile erhöht.

Das Frequenzumformermodul 200 kann im Wesentlichen stationär betrieben werden. Es kann aber auch möglich sein, den Boden 210 des Frequenzumformermoduls 200 derart auszugestalten, dass das Frequenzumformermodul 200 verfahrbar ist. Zum Beispiel können Räder oder Rollen an dem Boden 210 angeordnet sein. Vorzugsweise ist der Boden 210 als Schlitten ausgebildet, der es erlaubt, das Frequenzumformermodul 200 in einfacher Weise über eine Baustellenoberfläche zu ziehen, z.B. auch über Bewehrungen. Dadurch wird der Einsatz des Frequenzumformermoduls 200 vereinfacht.

Wie oben beschrieben ist es also möglich, in einfacher Weise mehrere Frequenzumformer zu einem Modul zu kombinieren, wobei die Frequenzumformer hinsichtlich ihrer Abmessungen und hinsichtlich ihrer die Frequenzumformung nicht betreffenden Komponenten identisch aufgebaut sind. Es versteht sich von selbst, dass es in einem derartigen Modul auch möglich ist, andere elektrische Bauteile innerhalb eines Gehäuses anzuordnen, das dem der Frequenzumformer entspricht. Damit kann die Funktionsweise des Frequenzumformermoduls erweitert werden, z.B. durch das Vorsehen einer Komponente, die Netzstrom über eine Mehrzahl von Steckdosen zur Verfügung stellt, ohne ihn zu wandeln.

## Patentansprüche

1. Frequenzumformermodul (200), mit
zumindest einem Frequenzumformer (100) zum Umformen einer Netzfrequenz in eine höhere Frequenz; und mit
einem Boden (210) und einem Deckel (220) zwischen denen der zumindest eine Frequenzumformer (100) angeordnet ist; wobei
der Frequenzumformer (100) eine Umformeraufnahme (110) aufweist, in der eine Platine (120) luftdicht vergossen ist, zum Transformieren eines an die Platine (120) angelegten elektrischen Stroms hinsichtlich seiner Frequenz, seiner Spannung und/oder seiner Phasenanzahl und zum Ausgeben des transformierten elektrischen Stroms;
der Frequenzumformer ein Gehäuse (130) aufweist, zum Aufnehmen der Umformeraufnahme (110);
das Gehäuse (130) derart ausgebildet ist, dass es mit einem Gehäuse (130) eines gleichartig aufgebauten weiteren Frequenzumformers (100) formschlüssig verbunden werden kann;
das Gehäuse (130) des zumindest einen Frequenzumformers (100) derart ausgebildet ist, dass ein weiterer gleichartig aufgebauter Frequenzumformer (100) an der Oberseite oder der Unterseite des zumindest einen Frequenzumformers (100) formschlüssig mit diesem verbunden werden kann, dass der Boden (210) an der Unterseite des zumindest einen Frequenzumformers (100) formschlüssig mit diesem verbunden werden kann, und dass der Deckel (220) an der Oberseite des zumindest einen Frequenzumformers (100) formschlüssig mit diesem verbunden werden kann;
das Frequenzumformermodul (200) portabel ist;
das Gehäuse (130) eine Kühlvorrichtung zum Kühlen der Platine (120) aufweist,
die Kühlvorrichtung zumindest einen Ventilator (142) aufweist, der geeignet ist, Luft von einem Lufteinlass (144) des Gehäuses (130) über einen entlang der Umformeraufnahme führenden Luftkanal (146) zu einem Luftauslass (148) des Gehäuses (130) zu führen; und wobei
der Luftkanal (146) zweifach geneigt ist, derart dass in den Luftkanal (146) gelangte Flüssigkeit in einer Betriebsstellung des Frequenzumformers (100) zum Lufteinlass (144) und zum Luftauslass (148) hin abläuft.

2. Frequenzumformermodul (200) gemäß Anspruch 1, wobei
die Platine (120) eine Transformatorschaltung zum Transformieren der Spannung des angelegten Stroms aufweist, vorzugsweise von einer Netzspannung von insbesondere 400V, 230V oder 120V auf eine niedrigere Spannung; und
die Platine (120) eine Frequenzwandelschaltung zum Transformieren der Frequenz des angelegten Stroms aufweist, vorzugsweise von einer Netzfrequenz von insbesondere 50Hz oder 60Hz auf eine höhere Frequenz.

3. Frequenzumformermodul (200) gemäß einem der vorherigen Ansprüche, wobei
die Frequenz des transformierten elektrischen Stroms eingestellt werden kann.

4. Frequenzumformermodul (200) gemäß einem der vorherigen Ansprüche, wobei
der Luftkanal (146) durch Kühlrippen (112) der Umformeraufnahme (110) läuft.

5. Frequenzumformermodul (200) gemäß einem der vorherigen Ansprüche, wobei
das Gehäuse (130) eine Signalisation (150) für verschiedene Betriebszustände aufweist, vorzugweise für einen der folgenden Betriebszustände: Betrieb des Frequenzumformers (100), Wartung notwendig, Überstrom, Überspannung, Übertemperatur.

6. Frequenzumformermodul (200) gemäß einem der vorstehenden Ansprüche, wobei
zumindest zwei Frequenzumformer (100) zwischen dem Boden (210) und der Decke (220) angeordnet sind; und
die zwei Frequenzumformer (100) unterschiedliche Stromstärken ausgeben, vorzugsweise aus der Gruppe von 20A, 35A und 54A.

7. Frequenzumformermodul (200) gemäß einem der vorstehenden Ansprüche, wobei
eine Außenwand (135) des Gehäuses (130) des zumindest einen Frequenzumformers (100) Steckdosen (160) zum Ausgeben des transformierten elektrischen Stroms aufweist; und
der Boden (210), der Deckel (220) und an die Außenwand (135) anschließende Teile des Gehäuses (130) gegenüber der Außenwand (135) derart vorspringen, dass sie sich weiter von der Außenwand (135) weg erstrecken als die Steckdosen (160).

8. Frequenzumformermodul (200) gemäß einem der vorstehenden Ansprüche, wobei
der Deckel (220) ein Potentiometer (230) aufweist, dass derart mit zwischen dem Boden (210) und dem Deckel (220) angeordneten Frequenzumformern (100) verschaltet werden kann, dass über das Potentiometer (230) ausgegebene Frequenzen eines, eines Teils oder aller Frequenzumformer (100) eingestellt werden können.

9. Frequenzumformermodul (200) gemäß einem der vorstehenden Ansprüche, wobei
die Frequenzumformern (100) ineinander gesteckt und durch Befestigungsmittel, vorzugsweise Verbindungsbolzen (240) oder Gewindestangen, aneinander und an dem Boden (210) und der Decke (220) befestigt werden können.

10. Frequenzumformermodul (200) gemäß einem der vorstehenden Ansprüche, wobei
das Frequenzumformermodul (200) ein Modul mit einem Gehäuse aufweist, das identisch zu dem Gehäuse (130) des zumindest einen Frequenzumformers (100) ausgebildet ist; und
das Modul geeignet ist, eine eingehenden Netzstrom über Steckdosen weiterzuleiten.

11. Frequenzumformermodul (200) gemäß einem der vorstehenden Ansprüche, wobei
der Boden (210) als Schlitten ausgebildet ist, derart, dass das Frequenzumformermodul über eine Baustelle gezogen werden kann.

## Claims

1. Frequency converter module (200), comprising
at least one frequency converter (100) for converting a mains frequency into a higher frequency; and comprising
a base (210) and a cover (220), between which the at least one frequency converter (100) is arranged; wherein
the frequency converter (100) comprises a converter receptacle (110), in which a circuit board (120) is encapsulated in an air-tight manner, for transforming an electrical current applied to the circuit board (120) with regard to its frequency, its voltage and/or its number of phases and for outputting the transformed electrical current;
the frequency converter has a housing (130) for accommodating the converter receptacle (110);
the housing (130) is configured such that it can be connected in a form-fitting manner to a housing (130) of a similarly constructed further frequency converter (100);
the housing (130) of the at least one frequency converter (100) is configured such that a further similarly constructed frequency converter (100) can be connected in a form-fitting manner to the at least one frequency converter (100) on the upper side or the lower side thereof, that the base (210) can be connected in a form-fitting manner to the at least one frequency converter (100) at the lower side thereof and that the cover (220) can be connected in a form-fitting manner to the at least one frequency converter (100) at the upper side thereof;
the frequency converter module (200) is portable;
the housing (130) has a cooling apparatus for cooling the circuit board (120), wherein
the cooling apparatus has at least one fan (142) which is suitable for guiding air from an air inlet (144) of the housing (130) via an air duct (146), which leads along the converter receptacle, to an air outlet (148) of the housing (130); and wherein
the air duct (146) is inclined in two ways such that liquid which has passed into the air duct (146) runs off to the air inlet (144) and to the air outlet (148) in an operating position of the frequency converter (100).

2. Frequency converter module (200) as claimed in claim 1, wherein
the circuit board (120) has a transformer circuit for transforming the voltage of the applied current, preferably from a mains voltage of in particular 400 V, 230 V or 120 V to a lower voltage; and
the circuit board (120) has a frequency converter circuit for transforming the frequency of the applied current, preferably from a mains frequency of in particular 50 Hz or 60 Hz to a higher frequency.

3. Frequency converter module (200) as claimed in any one of the preceding claims, wherein
the frequency of the transformed electrical current can be set.

4. Frequency converter module (200) as claimed in any one of the preceding claims, wherein
the air duct (146) runs through cooling ribs (112) of the transformer receptacle (110).

5. Frequency converter module (200) as claimed in any one of the preceding claims, wherein
the housing (130) has signalisation (150) for different operating states, preferably for one of the following operating states: operation of the frequency converter (100), maintenance required, overcurrent, overvoltage, excess temperature.

6. Frequency converter module (200) as claimed in any one of the preceding claims, wherein
at least two frequency converters (100) are arranged between the base (210) and the cover (220); and
the two frequency converters (100) output different strengths of current, preferably from the group of 20 A, 35 A and 54 A.

7. Frequency converter module (200) as claimed in any one of the preceding claims, wherein
an outer wall (135) of the housing (130) of the at least one frequency converter (100) has power points (160) for outputting the transformed electrical current; and
the base (210), the cover (220) and parts of the housing (130) adjoining the outer wall (135) protrude with respect to the outer wall (135) such that they extend further away from the outer wall (135) than the power points (160).

8. Frequency converter module (200) as claimed in any one of the preceding claims, wherein
the cover (220) has a potentiometer (230) which can be interconnected to frequency converters (100), which are arranged between the base (210) and the cover (220), such that frequencies of one, some or all of the frequency converters (100) which are output via the potentiometer (230) can be set.

9. Frequency converter module (200) as claimed in any one of the preceding claims, wherein
the frequency converters (100) can be inserted one inside the other and can be fastened to one another and to the base (210) and the cover (220) by means of fastening means, preferably connection bolts (240) or threaded rods.

10. Frequency converter module (200) as claimed in any one of the preceding claims, wherein
the frequency converter module (200) has a module with a housing which is identical to the housing (130) of the at least one frequency converter (100); and
the module is suitable for relaying an incoming mains current via power points.

11. Frequency converter module (200) as claimed in any one of the preceding claims, wherein
the base (210) is designed as a carriage such that the frequency converter module can be pulled across a construction site.

## Revendications

1. Module convertisseur de fréquence (200), avec
au moins un convertisseur de fréquence (100) pour convertir une fréquence de réseau en une fréquence plus élevée ; et avec
un fond (210) et un couvercle (220) entre lesquels est agencé au moins un convertisseur de fréquence (100) ; dans lequel
le convertisseur de fréquence (100) présente un logement de convertisseur (110) dans lequel un circuit imprimé (120) est scellé de manière étanche à l'air, pour transformer un courant électrique appliqué au circuit imprimé (120) en ce qui concerne sa fréquence, sa tension et/ou son nombre de phases et pour délivrer le courant électrique transformé ;
le convertisseur de fréquence présente un boîtier (130) pour recevoir le logement de convertisseur (110) ;
le boîtier (130) est conçu de telle sorte qu'il peut être relié par complémentarité de forme à un boîtier (130) d'un autre convertisseur de fréquence (100) de structure similaire ;
le boîtier (130) de l'au moins un convertisseur de fréquence (100) est conçu de telle sorte qu'un autre convertisseur de fréquence (100) de structure similaire peut être relié par complémentarité de forme à la face supérieure ou à la face inférieure de l'au moins un convertisseur de fréquence (100), que le fond (210) peut être relié par complémentarité de forme à la face inférieure de l'au moins un convertisseur de fréquence (100), et que le couvercle (220) peut être relié par complémentarité de forme à la face supérieure de l'au moins un convertisseur de fréquence (100) ;
le module convertisseur de fréquence (200) est portable ;
le boîtier (130) comporte un dispositif de refroidissement pour refroidir le circuit imprimé (120), le dispositif de refroidissement comportant au moins un ventilateur (142) qui est adapté pour guider l'air d'une entrée d'air (144) du boîtier (130) vers une sortie d'air (148) du boîtier (130) via un canal d'air (146) qui s'étend le long du logement du convertisseur ; et dans lequel
le canal d'air (146) est doublement incliné, de sorte que le liquide qui entre dans le canal d'air (146) s'écoule vers l'entrée d'air (144) et vers la sortie d'air (148) dans une position de fonctionnement du convertisseur de fréquence (100).

2. Module convertisseur de fréquence (200) selon la revendication 1, dans lequel
le circuit imprimé (120) comprend un circuit de transformation pour transformer la tension du courant appliqué, de préférence à partir d'une tension de réseau, en particulier de 400V, 230V ou 120V, en une tension moins élevée ; et
le circuit imprimé (120) comprend un circuit de conversion de fréquence pour transformer la fréquence du courant appliqué, de préférence à partir d'une fréquence de réseau, en particulier de 50Hz ou 60Hz, en une fréquence plus élevée.

3. Module convertisseur de fréquence (200) selon l'une des revendications précédentes, dans lequel
la fréquence du courant électrique transformé peut être ajustée.

4. Module convertisseur de fréquence (200) selon l'une des revendications précédentes, dans lequel le canal d'air (146) traverse des ailettes de refroidissement (112) du logement de convertisseur (110).

5. Module convertisseur de fréquence (200) selon l'une des revendications précédentes, dans lequel
le boîtier (130) comporte une signalisation (150) pour différents états de fonctionnement, de préférence pour l'un des états de fonctionnement suivants : Fonctionnement du convertisseur de fréquence (100), Maintenance nécessaire, Surintensité, Surtension, Surchauffe.

6. Module convertisseur de fréquence (200) selon l'une des revendications précédentes, dans lequel au moins deux convertisseurs de fréquence (100) sont agencés entre le fond (210) et le couvercle (220) ; et
les deux convertisseurs de fréquence (100) délivrent des intensités de courant différentes, de préférence choisies parmi 20A, 35A et 54A.

7. Module convertisseur de fréquence (200) selon l'une des revendications précédentes, dans lequel
une paroi extérieure (135) du boîtier (130) de l'au moins un convertisseur de fréquence (100) comporte des prises de courant (160) pour délivrer le courant électrique transformé ; et
le fond (210), le couvercle (220) et les parties du boîtier (130) adjacentes à la paroi extérieure (135) font saillie par rapport à la paroi extérieure (135) de manière à s'étendre plus loin de la paroi extérieure (135) que les prises de courant (160).

8. Module convertisseur de fréquence (200) selon l'une des revendications précédentes, dans lequel
le couvercle (220) présente un potentiomètre (230) qui peut être connecté à des convertisseurs de fréquence (100) agencés entre le fond (210) et le couvercle (220) de telle sorte que les fréquences d'un, d'une partie ou de tous les convertisseurs de fréquence (100) émises par le potentiomètre (230) peuvent être réglées.

9. Module convertisseur de fréquence (200) selon l'une des revendications précédentes, dans lequel
les convertisseurs de fréquence (100) peuvent être emboîtés les uns dans les autres et fixés les uns aux autres et au fond (210) et au couvercle (220) par des moyens de fixation, de préférence des boulons de liaison (240) ou des tiges filetées.

10. Module convertisseur de fréquence (200) selon l'une des revendications précédentes, dans lequel
le module convertisseur de fréquence (200) comprend un module ayant un boîtier de forme identique au boîtier (130) dudit au moins un convertisseur de fréquence (100) ;
et le module est adapté pour rediriger un courant de secteur entrant via des prises de courant.

11. Module convertisseur de fréquence (200) selon l'une des revendications précédentes, dans lequel
le fond (210) est conçu comme un chariot, de telle sorte que le module convertisseur de fréquence peut être tiré au-dessus d'un chantier.
